(19)

Europäisches
Patentamt
European
Patent Office
Office européen
des brevets

(11) **EP 2 685 275 A1**

(12) **EUROPEAN PATENT APPLICATION**

(43) Date of publication:
**15.01.2014 Bulletin 2014/03**

(51) Int Cl.:
**G01R 33/565** (2006.01)   **G01R 33/561** (2006.01)

(21) Application number: **12175561.5**

(22) Date of filing: **09.07.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **Koninklijke Philips N.V.**
**5656 AE Eindhoven (NL)**
• **Philips Intellectual Property & Standards GmbH**
**20099 Hamburg (DE)**

(72) Inventors:
• **Franz, Astrid**
**5600 AE Eindhoven (NL)**

• **Kabus, Sven**
**5600 AE Eindhoven (NL)**
• **Eggers, Holger**
**5600 AE Eindhoven (NL)**
• **Boernert, Peter**
**5600 AE Eindhoven (NL)**

(74) Representative: **Damen, Daniel Martijn**
**Philips**
**Intellectual Property & Standards**
**P.O. Box 220**
**5600 AE Eindhoven (NL)**

(54) **Improved correction of geometric distortions in echo-planar MRI**

(57)   The invention provides for magnetic resonance imaging system (400). Execution of instructions cause a processor (430) controlling the magnetic resonance imaging system to acquire first (444) and second (446) magnetic resonance data (444) using a first (440) and second (442) echo-planar imaging pulse sequence (440). The first and second echo-planar imaging pulse sequences have phase encoding gradients with opposite polarities. The instructions cause the processor to reconstruct a first (448) and second (450) image using the first and second magnetic resonance data. The instructions cause the processor to create a first (452) and second (454) corrected images by applying a first intensity mapping algorithm to the image. The processor further calculates a first displacement field (456) using the first and second corrected images by performing an elastic registration. The processor further creates a transformed image pair (458) using the first displacement field. Thus, the invention enables to correct for geometric distortions in the context of EPI using the reversed gradient method.

FIG. 5

EP 2 685 275 A1

## Description

### TECHNICAL FIELD

The invention relates to magnetic resonance imaging, in particular to echo-planar imaging.

### BACKGROUND OF THE INVENTION

In the magnetic resonance imaging method of echo-planar imaging, the presence of field inhomogeneity leads to significant image distortion. Not only the spatial position, but also the image intensity is distorted. In the journal article, H. Chang, J.M. Fitzpatrick: A Technique for Accurate Magnetic Resonance Imaging in the Presence of Field Inhomogeneities. IEEE Transactions on Medical Imaging 11: 319-329 (1992) a method of correcting for magnetic field inhomogeneities, which does not require a priori knowledge of the magnetic field variations, is disclosed. It is an attempt to correct the geometric distortion induced by both main field inhomogeneities and object susceptibilities by using two magnitude images acquired with opposite polarity of the phase encoding gradient. This approach is based on the fact that for two corresponding image locations $x_1$ and $x_2$ in the two images, the integrals of the image intensity along the phase encoding direction up to these positions have to be identical: $\int_{-\infty}^{x_1} I_1(x)dx = \int_{-\infty}^{x_2} I_2(x)dx$. . Given a pair $(x_1, x_2)$ fulfilling this integral condition, the true position x and the true image intensity $I(x)$ can be obtained as $x = \dfrac{x_1 + x_2}{2}$ and $I(x) = \dfrac{2 \cdot I_1(x_1) \cdot I_2(x_2)}{I_1(x_1) + I_2(x_2)}$. . The integral condition describes the preservation of energy in the two images. This energy preservation can also be considered locally, hence an elastic registration approach with intensity correction (reducing the intensity in expanded regions and enlarging the intensity in compressed regions) can be used to obtain distortion corrected images.

The method disclosed in Chen has the disadvantage that it relies on the image energy being preserved. However in real world situations, the image energy of echo-planar images is often not preserved due to the complex nature of the artifacts. Hence a distortion correction based on the assumption of energy preservation may fail, typically causing a duplication of image structures. Especially image structures with low intensity, as blood vessels, are at risk to be duplicated. This doubling of structures may make the images unusable in a clinical setting.

## SUMMARY OF THE INVENTION

The invention provides for a magnetic resonance imaging system, a computer program product, and a method in the independent claims. Embodiments are given in the dependent claims.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network. Computer executable code embodied on a computer readable medium may be transmitted using any appropriate medium, including but not limited to wireless, wireline, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It will be understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, gear sticks, steering wheel, pedals, wired glove, dance pad, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bistable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

Medical image data is defined herein as two or three dimensional data that has been acquired using a medical imaging scanner. A medical imaging scanner is defined herein as an apparatus adapted for acquiring information about the physical structure of a patient and construct sets of two dimensional or three dimensional medical image data. Medical image data can be used to construct visualizations which are useful for diagnosis by a physician. This visualization can be performed using a computer.

Magnetic Resonance (MR) data is defined herein as being the recorded measurements of radio frequency signals emitted by atomic spins by the antenna of a Magnetic resonance apparatus during a magnetic resonance imaging scan. Magnetic resonance data is an example of medical image data. A Magnetic Resonance Imaging (MRI) image is defined herein as being the reconstructed two or three dimensional visualization of anatomic data contained within the magnetic resonance imaging data. This visualization can be performed using a computer.

An 'elastic registration' as used herein encompasses an image registration method for mapping one image onto another image using a smooth transformation. Elastic registrations typically assume that regions being matched have similar intensities. Examples of elastic registration method include, but are not limited to: optical flow method, gradient of intensity method, Bayesian method which maximizes the probability that the transformation is the optimal transformation, models which use local deformation, viscous fluid approach method, basis function method which models the deformation field as a linear combination of smooth basis functions, and spline-based registration.

In one aspect the invention provides for a magnetic resonance imaging system for acquiring magnetic resonance data from an imaging zone. The magnetic resonance imaging system comprises a magnet for generating a static field within the imaging zone. The magnetic resonance imaging system further comprises a gradient coil system for generating a gradient magnetic field within the imaging zone. The magnetic resonance imaging system further comprises a processor for controlling the magnetic resonance imaging system. The magnetic resonance imaging system further comprises a memory for storing machine-executable instructions for execution by the processor.

Execution of the instructions causes the processor to acquire first magnetic resonance data using a first echo-planar imaging pulse sequence. The first echo-planar imaging pulse sequence is operable to cause the gradient coil amplifier to generate a phase-encoding gradient with a first polarity. Where it is stated that the processor acquires magnetic resonance data it is understood that the processor controls the magnetic resonance imaging system to acquire the magnetic resonance data. The first magnetic resonance data is magnetic resonance data. A pulse sequence as used herein is a sequence of controls or a representation of controls which may be readily converted into controls which provide time-dependent actions taken by the magnetic resonance imaging system to acquire magnetic resonance data. Echo-planar imaging pulse sequences enable the magnetic resonance imaging system to use the echo-planar imaging technique for acquiring magnetic resonance data. This embodiment of the invention may be advantageous, because it may provide a means of correcting for magnetic field inhomogeneities without an assumption that the image energy is preserved.

Execution of the instructions further cause the processor to acquire second magnetic resonance data using a second echo-planar imaging pulse sequence. The second echo-planar imaging pulse sequence is operable to cause the gradient coil amplifier to generate the phase-encoding gradient with a second polarity. The first polarity and the second polarity have opposite values. Essentially magnetic resonance data is acquired using the first echo-planar imaging pulse sequence and the second echo-planar imaging pulse sequence. The polarity of the phase-encoding gradients is opposite from each other.

Execution of the instructions further causes the processor to reconstruct a first image using the first magnetic resonance data. Execution of the instructions further causes the processor to reconstruct a second image using the second magnetic resonance data. Execution of the instructions further causes the processor to create a first corrected image by applying a first intensity mapping algorithm to the first image. Execution of the instructions further causes the processor to create a second corrected image by applying the first intensity mapping algorithm to the second image. The first intensity mapping algorithm is an algorithm which takes the value of the particular pixel in the image and maps it to a different value. For instance the first intensity mapping algorithm may limit the maximum intensity to a particular value or it may also take a particular dynamic range of the image and map this to the corrected images.

Execution of the instructions further causes the processor to calculate a first displacement field between the first corrected image and the second corrected image by performing an elastic registration. Essentially the elastic registration maps one image onto the other image. Execution of the instructions further causes the processor to create a transformed image pair by transforming at least one of the first image and the second image using the first displacement field. The first displacement field is a mapping between one image and the other image. Typically the transformed image pair will be created by transforming one of the images by half of the first displacement field and transforming the other image by the inverse of half the first displacement field. However other possibilities exist and in some cases it may be preferable to transform one image into the other.

The first displacement field may also be referred to as a primary displacement field. It should be noted that the steps performed by the processor may also be performed on multiple slices of magnetic resonance imaging data. However the first and second images are from essentially the same slice or spatial location within the subject. In some embodiments the transformed pair may be displayed on a display or stored in memory for further use.

This embodiment may be beneficial because it may provide an improved method of compensating or correcting for magnetic field inhomogeneities in echo-planar imaging.

In another embodiment execution of the instructions further cause the processor to create multiple first corrected images by applying multiple-intensity mapping algorithms to the first image. Execution of the instructions further causes the processor to create multiple second corrected images by applying the multiple intensity mapping algorithm to the second image. Execution of the instructions further cause the processor to calculate multiple displacement fields between the multiple first corrected images and the multiple second corrected images by performing an elastic registration between the corresponding second corrected images and the first corrected images. By corresponding it is meant that there are the first image and second image which had the same intensity mapping algorithm applied to it. Execution of the instructions further causes the processor to calculate an average displacement field using the multiple displacement fields. Execution of the instructions further causes the processor to transform at least one of the first image and the second image using the average displacement field. The first displacement field is one of the multiple displacement fields. The first corrected image is one of the multiple first corrected images. The second corrected image is one of the multiple second corrected images. This embodiment may be advantageous because the results of the elastic registration may vary depending upon which intensity mapping algorithm is applied. In this embodiment multiple intensity mapping algorithms are applied to the first and second images. This is used to create a number of displacement fields which are then averaged to create an average displacement field.

In another embodiment execution of the instructions further causes the processor to create a third corrected image by applying a second intensity mapping algorithm to the first image. Execution of the instructions further cause the processor to create a fourth corrected image by applying the second intensity mapping algorithm to the second image. Execution of the instructions further cause the processor to calculate a second displacement field between the first corrected image and the second corrected image by performing an elastic registration. Execution of the instructions further cause the processor to calculate an average displacement field using the first displacement field and the second displacement field. Execution of the instructions further causes the processor to transform at least one of the first image and the second image using the average displacement field. In this embodiment two different intensity mapping algorithms are used in the process of calculating the first displacement field and the second displacement field. This embodiment may be beneficial because it may lead to a more accurate calculation of the displacement field.

In another embodiment the transformed image pair comprises a first transformed image and a second transformed image. Execution of the instructions further cause the processor to iteratively calculate the transformed image pair by substituting the first transformed image for the first image and substituting the second transformed image for the second image.

In another embodiment execution of the instructions further causes the processor to use a different intensity mapping algorithm for each iteration. There for instance could be multiple intensity mapping algorithms and a different intensity mapping algorithm is selected for each iteration. This may include setting different threshold values within a particular intensity mapping algorithm or it may use a completely different intensity mapping algorithm.

In another embodiment execution of the instructions further cause the processor to calculate a concatenated image displacement field by concatenating each of the first displacement fields calculated in each iteration. Execution of the instructions further cause the processor to create a concatenated transformed image pair by transforming at least one of the first image and the second image using at least the concatenated displacement field.

In another embodiment the transformed image pair comprises a first transformed image and a second transformed image. Execution of the instructions further cause the processor to create a third corrected image by applying the first intensity mapping algorithm to the first transformed image. Execution of the instructions further cause the processor to create a fourth corrected image by applying the first intensity mapping algorithm to the second transformed image. Execution of the instructions further cause the processor to calculate a transformed image displacement field between the third corrected image and the fourth corrected image by performing an elastic registration. Execution of the instructions further cause the processor to calculate a concatenated image displacement field by concatenating the first displacement field and the transformed image displacement field. Execution of the instructions further cause the processor to create a concatenated transformed image pair by transforming at least one of the first image and the second image using at least the concatenated image displacement field.

In another embodiment the transformed image pair comprises a first transformed image and a second transformed image.

In another embodiment execution of the instructions further causes the processor to create a third corrected image by applying a second intensity mapping algorithm to the first transformed image. Execution of the instructions further cause the processor to create a fourth corrected image by applying the second intensity mapping algorithm to the second transformed image. Execution of the instructions further cause the processor to calculate a transformed image displacement field between the third corrected image and the fourth corrected image by performing an elastic registration. Execution of the instructions further cause the processor to calculate a concatenated image displacement field by concatenating the first displacement field and the transformed image displacement field. Execution of the instructions further cause the processor to create a concatenated image pair by transforming at least one of the first image and the second image using at least the concatenated image displacement field.

In another embodiment the creation of a concatenated image pair by transforming at least one of the first image and the second image using the at least the concatenated image displacement field is performed according to any one of the following: transforming the first image by the concatenated image displacement field; transforming the second image by the inverse of the concatenated image displacement field; and transforming the first image by one half of the concatenated image displacement field and transforming the second image by the inverse of one half of the concatenated image displacement field.

In another embodiment the elastic registration is performed using an elastic registration algorithm. The elastic registration algorithm comprises a local search routine adapted for receiving a starting search location. Execution of the instructions further cause the processor to iteratively calculate the transformed image pair by using the first displacement field of one iteration as the starting search location for a subsequent iteration. In some embodiments a different intensity mapping algorithm is used for each iteration. In some embodiments this iterative method is performed every time on the original first image and second image.

In another embodiment execution of the instructions further causes the processor to apply an intensity correction to the first image and the second image after transforming at least one of the first image and the second image using the displacement. This for instance may include normalizing the image.

In another embodiment execution of the instructions further cause the processor to create an averaged image by averaging the transformed image pair. The averaged image may for instance be displayed on a display or stored in memory for further use by the processor. The other images generated by embodiments of the invention may also be displayed on a display or stored in memory for further use by the processor.

In another embodiment the first displacement field maps the first image onto the second image. The creation of a transformed image pair by transforming at least one of the first image and the second image using at least the first displacement field is performed according to any one of the following: transforming the first image by the displacement field; transforming the second image by the inverse of the first displacement field; and transforming the first image by one half of the first displacement field and transforming the second image by the inverse of one half of the first displacement field.

One half of a displacement field is defined as the displacement field with its magnitude reduced by a factor of 2.

In another embodiment the intensity mapping algorithm is any one of the following: a thresholding algorithm for generating a black and white image using a predetermined threshold, an intensity mapping algorithm with a predetermined intensity mapping, an algorithm which limits the maximum intensity to a predetermined intensity threshold, and an algorithm which limits the dynamic range of the image. These algorithms may also be applied to the second intensity mapping algorithm or the multiple intensity mapping algorithms discussed in previous embodiments.

In another aspect the invention provides for a computer program product comprising machine-executable instructions for execution by a processor controlling a magnetic resonance imaging system. The magnetic resonance imaging system is operable for acquiring magnetic resonance data from an imaging zone. The magnetic resonance imaging system comprises a magnet for generating a static magnetic field within the imaging zone. The magnetic resonance imaging system further comprises a gradient coil system for generating a gradient magnetic field within the imaging zone. Execution of the instructions further cause the processor to acquire first magnetic resonance data using a first echo-planar imaging pulse sequence. The first echo-planar imaging pulse sequence is operable to cause the gradient coil amplifier to generate a phase-encoding gradient with a first polarity. Execution of the instructions further cause the processor to acquire second magnetic resonance data using a second echo-planar imaging pulse sequence.

The second echo-planar imaging pulse sequence is operable to cause the gradient coil amplifier to generate the pulse encoding the gradient with a second polarity. The first polarity and the second polarity have opposite values. Execution of the instructions further causes the processor to reconstruct a first image using the first magnetic resonance data. Execution of the instructions further causes the processor to reconstruct a second image using the second magnetic resonance data. Execution of the instructions further causes the processor to create a first corrected image by applying a first intensity mapping algorithm to the first image. Execution of the instructions further causes the processor to create a second corrected image by applying the first intensity mapping algorithm to the second image. Execution of the instructions further cause the processor to calculate a first displacement field between the first corrected image and the second corrected image by performing an elastic registration. Execution of the instructions further cause the processor to create a transformed image pair by transforming at least one of the first image and the second image using at least the first displacement field.

In another aspect the invention provides for a method of operating a magnetic resonance imaging system. A magnetic resonance imaging system is operable for acquiring magnetic resonance data from an imaging zone. The magnetic resonance imaging system comprises a magnet for generating a static magnetic field within the imaging zone. The magnetic resonance imaging system further comprises a gradient coil system for generating a gradient magnetic field within the imaging zone. The method comprises the step of acquiring first magnetic resonance data using a first echo-planar imaging pulse sequence. The first echo-planar imaging pulse sequence is operable to cause the gradient coil amplifier to generate a phase-encoding gradient with a first polarity. The method further comprises the step of acquiring second magnetic resonance data using a second echo-planar imaging pulse sequence. The second echo-planar imaging pulse sequence is operable to cause the gradient coil amplifier to generate the phase-encoding gradient with a second polarity. The first polarity and the second polarity have opposite values.

The method further comprises the step of reconstructing a first image using the first magnetic resonance data. The method further comprises the step of reconstructing a second image using the second magnetic resonance data. The method further comprises the step of creating a first corrected image by applying a first intensity mapping algorithm to the first image. The method further comprises the step of creating a second corrected image by applying the first intensity mapping algorithm to the second image. The method further comprises the step of calculating a first displacement field between the first corrected image and the second corrected image by performing an elastic registration. The method further comprises the step of creating a transformed image pair by transforming at least one of the first image and the second image using at least the first displacement field.

It is understood that one or more of the aforementioned embodiments of the invention may be combined as long as the combined embodiments are not mutually exclusive.

BRIEF DESCRIPTION OF THE DRAWINGS

In the following preferred embodiments of the invention will be described, by way of example only, and with reference to the drawings in which:

Fig. 1 shows a flowchart which illustrates a method according to an embodiment of the invention;
Fig. 2 shows a flowchart which illustrates a method according to a further embodiment of the invention;
Fig. 3 shows a flowchart which illustrates a method according to a further embodiment of the invention;
Fig. 4 illustrates a magnetic resonance imaging system according to an embodiment of the invention; and
Fig. 5 shows a flowchart which illustrates the workflow of the magnetic resonance imaging system of Fig. 4.

DETAILED DESCRIPTION OF THE EMBODIMENTS

Like numbered elements in these figures are either equivalent elements or perform the same function. Elements which have been discussed previously will not necessarily be discussed in later figures if the function is equivalent.

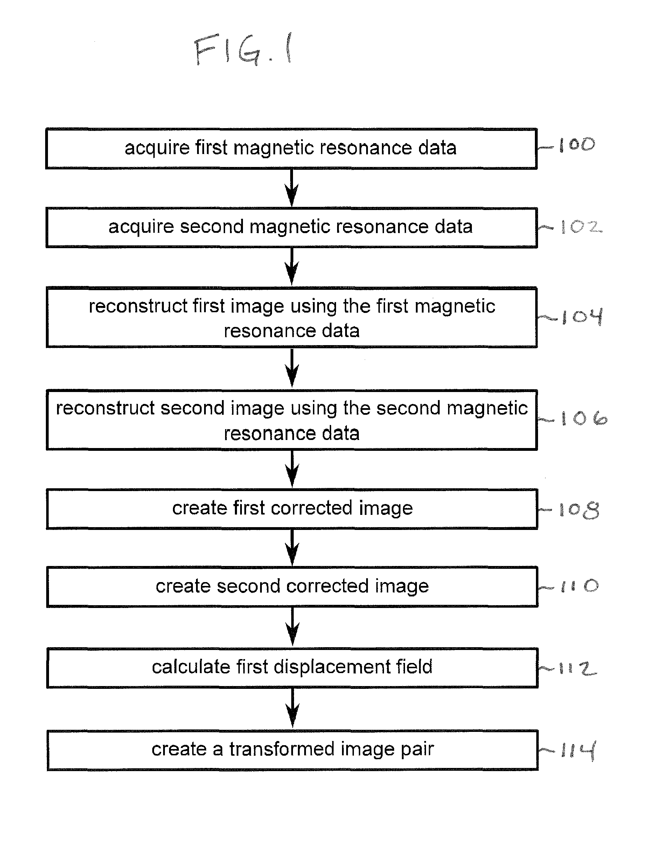

Fig. 1 shows a flowchart which illustrates a method according to an embodiment of the invention. Step 100 first magnetic resonance data is acquired using a first echo-planar imaging pulse sequence. The first echo-planar imaging pulse sequence is operable to cause the gradient coil amplifier to generate a phase-encoding gradient with a first polarity. Next in step 102 second magnetic resonance data is acquired using a second echo-planar imaging pulse sequence. The second echo-planar imaging pulse sequence is operable to cause the gradient coil amplifier to generate the phase-encoding gradient with a second polarity. The first polarity and the second polarity have opposite values. Next in step 104 a first image is reconstructed using the first magnetic resonance data. Next in step 106 a second image is reconstructed using the second magnetic resonance data. In step 108 a first corrected image is created by applying a first intensity mapping algorithm to the first image. In step 110 a second corrected image is created by applying the first intensity mapping algorithm to the second image. Next in step 112 a first displacement field is calculated between the first corrected image and the second corrected image by performing an elastic registration. Finally in step 114 a transformed image pair is created by transforming at least one of the first image and the second image using at least the first displacement field.

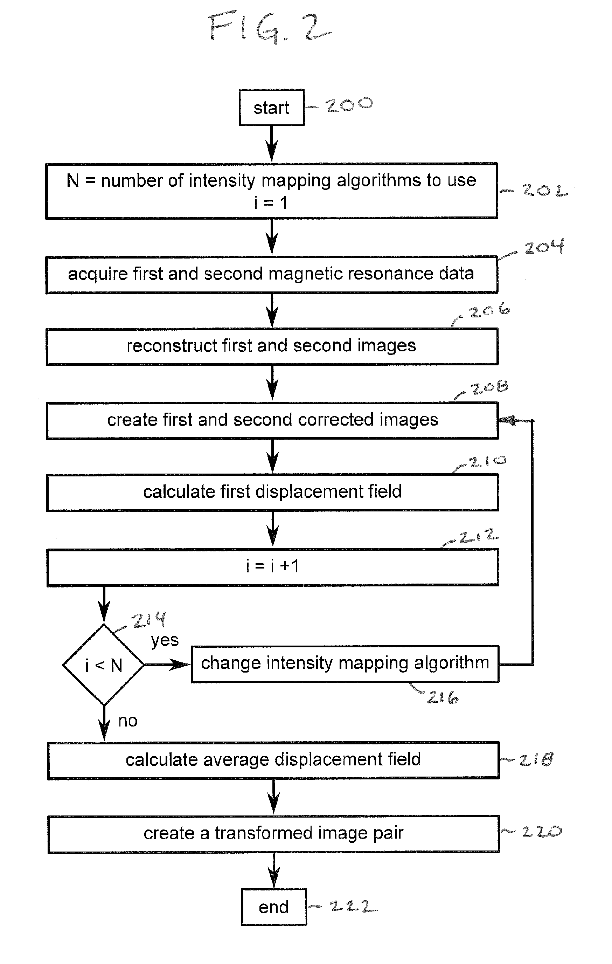

Fig. 2 shows a flowchart which illustrates the method according to a further embodiment of the invention. First in step 200 the method starts. In step 202 the number of intensity mapping algorithms to use is set and an index variable i is set equal to 1. In step 204 the first magnetic resonance data is acquired using a first echo-planar imaging pulse sequence where the first echo-planar imaging pulse sequence is operable to cause the gradient coil amplifier to generate a phase-encoding gradient with a first polarity. Also in step 204 second magnetic resonance data is acquired using a second echo-planar imaging pulse sequence. The second echo-planar imaging pulse sequence is operable to cause the gradient coil amplifier to generate the phase-encoding gradient with a second polarity. The first polarity and the second polarity are opposite. Next in step 206 a first image is reconstructed using the first magnetic resonance data and a second image is reconstructed using the second magnetic resonance data. In step 208 a first corrected image is created by applying a first intensity mapping algorithm to the first image and a second corrected image is created by applying the first intensity mapping algorithm to the second image. Next in step 210 a first displacement field is calculated between the first corrected image and the second corrected image by performing an elastic registration. Next in step 212 the index variable is advanced by a value of 1. Step 214 is a question box, if i is less than n then the method proceeds to step 216, if it is no then the method proceeds to box 218. In box 216 the intensity mapping algorithm that is used is changed and the method proceeds back to step 208 and the method proceeds again through steps 208, 210, 212 and back to the question box 214. This loop continues until all of the different desired intensity mapping algorithms have been used and have been used to calculate different first displacement fields. If i is greater than or equal to n then the method proceeds to box 218. In this case all of the first displacement fields that were calculated in the iterations in box 210 are used to calculate an average displacement field. Next in step 220 the average displacement field is used to create a transformed image pair by transforming at least one of the first image and the second image using the first displacement field. And finally the method stops in step 222.

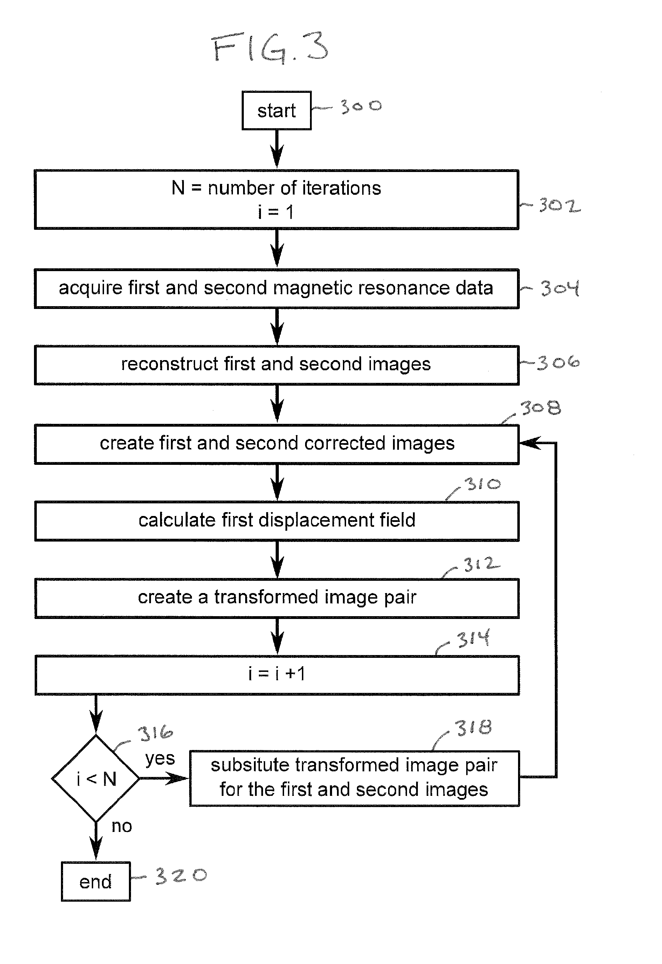

Fig. 3 illustrates a flow diagram according to a further embodiment of the invention. The method starts in step 300. In step 302 the number of iterations is set and the index variable i is set to be equal to 1. Next in step 304 first and second magnetic resonance data are acquired. Step 304 is equivalent to step 204 in Fig. 2. Next in step 306 first and second images are reconstructed. Step 306 is equivalent to step 206 in Fig. 2. In step 308 first and second corrected images are created. Step 308 is equivalent to step 208 in Fig. 2. Next in step 310 a first displacement field is calculated. Step 310 in Fig. 3 is equivalent to step 210 in Fig. 2. Next a transformed image pair is created by transforming at least one of the first image and the second image using the first displacement field. In step 314 the index variable i is incremented by 1. Box 316 is a question box, if i is less than n then box 318 is performed, if not the method ends at step 320. In box 318 the transformed image pair calculated in step 312 is substituted for the first and the second corrected images and the method proceeds back to step 308 and the method continues repeating steps 210, 312 and 314 in a loop until i is greater than or equal to n.

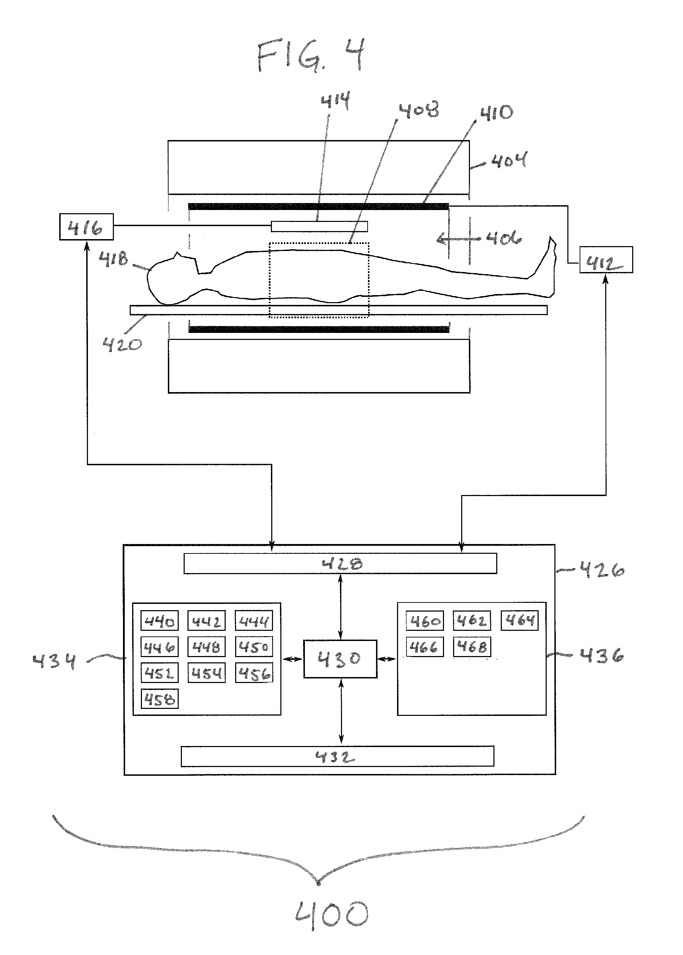

Fig. 4 illustrates an example of a magnetic resonance imaging system 400 according to an embodiment of the invention. The magnetic resonance imaging system 400 comprises a magnet 404. The magnet 400 is a superconducting cylindrical type magnet 400 with a bore 506 through it. The use of different types of magnets is also possible for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils. Within the bore 406 of the cylindrical magnet 404 there is an imaging zone 408 where the magnetic field is strong and uniform enough to perform magnetic resonance imaging.

Within the bore 406 of the magnet there is also a set of magnetic field gradient coils 410 which is used for acquisition of magnetic resonance data to spatially encode magnetic spins within the imaging zone 408 of the magnet 404. The magnetic field gradient coils 410 connected to a magnetic field gradient coil power supply 412. The magnetic field gradient coils 410 are intended to be representative. Typically magnetic field gradient coils 410 contain three separate sets of coils for spatially encoding in three orthogonal spatial directions. A magnetic field gradient power supply supplies current to the magnetic field gradient coils. The current supplied to the magnetic field gradient coils 410 is controlled as a function of time and may be ramped or pulsed.

Adjacent to the imaging zone 408 is a radio-frequency coil 414 for manipulating the orientations of magnetic spins within the imaging zone 408 and for receiving radio transmissions from spins also within the imaging zone 408. The radio frequency antenna may contain multiple coil elements. The radio frequency antenna may also be referred to as a channel or antenna. The radio-frequency coil 414 is connected to a radio frequency transceiver 416. The radio-frequency coil 414 and radio frequency transceiver 416 may be replaced by separate transmit and receive coils and a separate transmitter and receiver. It is understood that the radio-frequency coil 414 and the radio frequency transceiver 416 are representative. The radio-frequency coil 414 is intended to also represent a dedicated transmit antenna and a dedicated receive antenna. Likewise the transceiver 416 may also represent a separate transmitter and receivers.

The magnetic field gradient coil power supply 412 and the transceiver 416 are connected to a hardware interface 428 of computer system 426. The computer system 426 further comprises a processor 430. The processor 430 is connected to the hardware interface 428, a user interface 432, computer storage 634, and computer memory 436. The computer storage 434 is shown as containing the first echo-planar imaging pulse sequence 440 and the second echo-planar imaging pulse sequence 442. The first and second echo-planar imaging pulse sequences have phase-encoding gradients with opposite polarities. The computer storage 434 is shown as further containing first magnetic resonance data 444 that was acquired by the magnetic resonance imaging system 400 using the first echo-planar imaging pulse sequence. The computer storage 434 is further shown as containing second magnetic resonance data which was acquired using the magnetic resonance imaging system 400 and the second echo-planar imaging pulse sequence. The computer storage 434 is further shown as containing a first image 448 which was reconstructed from the first magnetic resonance data 444. The computer storage 434 is further shown as containing a second image 450 which was reconstructed from the second magnetic resonance data 446. The computer storage 434 is further shown as containing a first corrected image 452 that was calculated from the first image 448. The computer storage 434 is further shown as containing a second corrected image 454 which was calculated using the second image 450. The computer storage 434 is further shown as containing a first displacement field 456 which was calculated using the first corrected image 452 and the second corrected image 454. The computer storage 434 is further shown as containing a transformed image pair 458 which was calculated using the first image 448, the second image 450, and the first displacement field 456.

The computer memory 436 is shown as containing a control module 460. The control module 460 contains computer-executable code which enables the processor 430 to control the operation and function of the magnetic resonance imaging system 400. It also enables the basic operations of the magnetic resonance imaging system 400 such as the acquisition of magnetic resonance data. The processor 430 used the control module 460 and the first echo-planar imaging pulse sequence 440 and the second echo-planar imaging pulse sequence 442 to acquire the first and second magnetic resonance data 444, 446. The computer memory 436 is further shown as containing an image reconstruction module 462. The image reconstruction module 462 contains computer-executable code which enables the processor 430 to calculate the first image 448 from the first magnetic resonance data 444 and the second image 450 from the second magnetic resonance data 446.

The computer memory 436 is further shown as containing an intensity mapping algorithm module 464. The intensity mapping algorithm module 464 contains computer-executable code which enabled the processor 430 to apply the first intensity mapping algorithm to the first image 448 to calculate the first corrected image 452. The intensity mapping algorithm module 464 also enabled the processor 430 to calculate the second corrected image 454 from the second image 450. The computer memory 436 is further shown as containing an elastic registration module 446. The elastic registration module 446 contains computer-executable code which enabled the processor 430 to calculate the first displacement field 456 using the first corrected image 452 and the second corrected image 454. The computer memory 436 is shown as containing an image transformation module 468. The image transformation module 468 contains computer-executable code which enabled the processor 430 to calculate the transformed image pair 458 by applying the first displacement field 456 to at least one of the first image 448 and the second image 450.

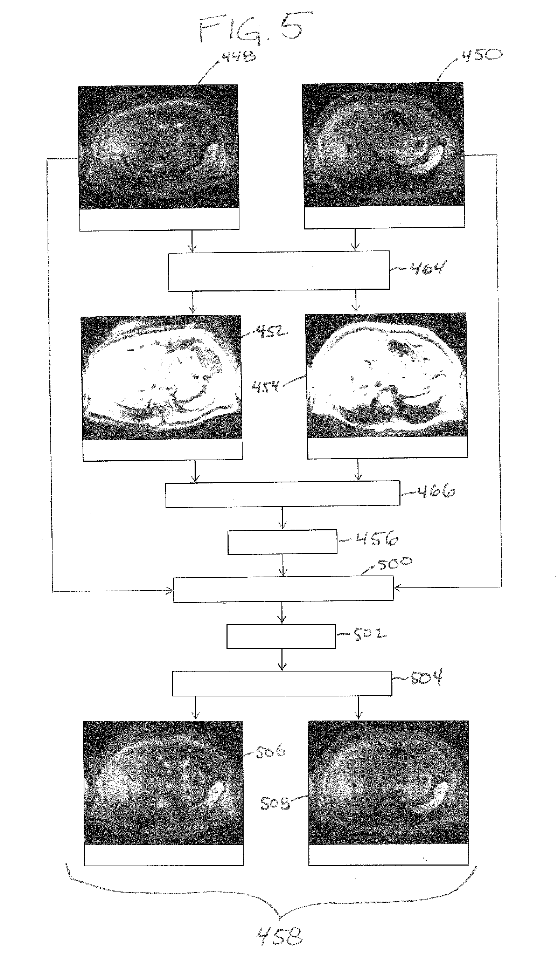

Fig. 5 illustrates the workflow of the magnetic resonance imaging system 400 shown in Fig. 4. First in Fig. 5 at the top the first image 448 and the second image 450 are shown. Next box 464 represents the intensity mapping algorithm module being applied to the first image 448 and the second image 450. The intensity mapping algorithm calculates the first corrected image 452 from the first image 448. The intensity mapping algorithm module 464 also calculates the second corrected image 454 from the second image 450. Box 466 represents the elastic registration module 466. The elastic registration module 466 calculates the first displacement field 456 using the first corrected image 452 and the second corrected image 454 as inputs. The block 500 represents applying the displacement field 456 to the original images 448 and 450. Block 500 takes the displacement field 456 and the first image 448 and second image 450 as inputs. Next in block 502 a second displacement field is calculated by applying a second elastic registration module to the two images resulting from block 500. Finally in block 504 an optional intensity correction and the elastic registration are applied to the two images resulting from block 500. Blocks 500, 502, and 504 are used to calculate the transformed image pair 458. The transformed image pair 458 shows a transformed image 506 and a second transformed image 508.

When performing echo-planar imaging, the image energy is often not preserved due to the complex nature of the artifacts. Hence a distortion correction based on the assumption of global energy preservation fails, typically causing a duplication of image structures. Especially image structures with low intensity, as blood vessels, are at risk to be duplicated. This doubling of structures is inacceptable in clinical practice, because it can spoil diagnosis.

The method illustrated in Fig. 5 is a two-step elastic registration approach for EPI distortion correction. First, the images 448, 450 are thresholded 464 by the mean intensity, i.e. all intensity values above mean are set to the mean intensity or close to it. These images are then elastically registered 466. Since the high intensity structures are thresholded, the registration focuses on matching the low intensity structures, for instance blood vessels (signal voids) and / or the bulk image structures. The resulting displacement field 456 is then used to initialize or regularize a second elastic registration 500 working on the original image intensities. Now the high intensity structures mainly drive the registration process. At the end, the low as well as the high intensity structures are sufficiently matched.

In the preprocessing step 464, the input images are thresholded by the mean intensity. These thresholded images 452, 454 serve as input for the first registration step 466, the elastic registration without intensity correction. Since the input image intensities are modified, intensity correction due to local compression or expansion would not be useful and is, therefore, not applied in this first elastic registration. The result of step 466 is a displacement field 456. When applying half of the displacement field 456 to the thresholded one of the images and applying half of the negative displacement field to the other image, these images are then optimally matched (optimal with respect to the objective function used in the elastic registration process 466). Now the original (non-thresholded) images 448, 450. and the displacement field 456 are used as input for the second registration step 502, the elastic registration with intensity correction. To perform this, in step 500 the first image 448 is deformed by half of the given displacement field 456 and the second image 450 is deformed by half of the negative displacement field 456. As mentioned above, these two deformed images are matched by a second elastic registration in step 502. In some embodiments an optional intensity correction is also calculated in step 502. Now in step 504 the displacement field resulting from the second elastic registration 502 and the optional intensity correction are applied, reducing the intensities in expanded regions and enlarging the intensities in compressed regions, due to the energy preservation. The final deformed images 458 are the distortion corrected images 506, 508 which match and can be used for further processing. Depending on the clinical application, also an appropriate combination of the two deformed images could be used.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

LIST OF REFERENCE NUMERALS

| | |
|---|---|
| 400 | magnetic resonance imaging system |
| 404 | magnet |
| 406 | bore of magnet |
| 408 | imaging zone |
| 410 | magnetic field gradient coils |
| 412 | magnetic field gradient coil power supply |
| 414 | radio-frequency coil |
| 416 | transceiver |
| 418 | subject |
| 420 | subject support |
| 426 | computer system |
| 428 | hardware interface |
| 430 | processor |
| 432 | user interface |
| 436 | computer storage |
| 438 | computer memory |
| 440 | first echo-planar imaging pulse sequence |
| 442 | second echo-planar imaging pulse sequence |
| 444 | first magnetic resonance data |
| 446 | second magnetic resonance data |
| 448 | first image |
| 450 | second image |
| 452 | first corrected image |
| 454 | second corrected image |
| 456 | first displacement field |
| 458 | transformed image pair |
| 460 | control module |
| 462 | image reconstruction module |
| 464 | intensity mapping algorithm module |
| 466 | elastic registration module |
| 468 | image transformation module |

500     image transformation module
502     elastic registration module
504     second displacement field
506     image transformation module with optional intensity correction
506     first transformed image
508     second transformed image

**Claims**

1.  A magnetic resonance imaging system (400) for acquiring magnetic resonance data (444, 446) from an imaging zone (408), wherein the magnetic resonance imaging system comprises:

    - a magnet (404) for generating a static magnetic field within the imaging zone;
    - a gradient coil system (410, 412) for generating a gradient magnetic field within the imaging zone;
    - a processor (430) for controlling the magnetic resonance imaging system;
    - a memory (436) for storing machine executable instructions (460, 462, 464, 466, 468) for execution by the processor, wherein execution of the instructions cause the processor to:

        - acquire (100, 204, 304) first magnetic resonance data (444) using a first echo-planar imaging pulse sequence (440), wherein the first echo-planar imaging pulse sequence is operable to cause the gradient coil amplifier to generate a phase encoding gradient with a first polarity.
        - acquire (102, 204, 304) second magnetic resonance data (446) using a second echo-planar imaging pulse sequence (442), wherein the second echo-planar imaging pulse sequence is operable to cause the gradient coil amplifier to generate the phase encoding gradient with a second polarity, wherein the first polarity and the second polarity have opposite values;
        - reconstruct (104, 206, 306) a first image (448) using the first magnetic resonance data;
        - reconstruct (106, 206, 306) a second image (450) using the second magnetic resonance data;
        - create (108, 208, 308) a first corrected image (452) by applying a first intensity mapping algorithm to the first image;
        - create (110, 208, 308) a second corrected image (454) by applying the first intensity mapping algorithm to the second image;
        - calculate (112, 210, 310) a first displacement field (456) between the first corrected image and the second corrected image by performing an elastic registration; and
        - create (114, 220, 312) a transformed image pair (458) by transforming at least one of the first image and the second image using at least the first displacement field.

2.  The magnetic resonance imaging system of claim 1, wherein execution of the instructions further causes the processor to:

        - create (208) multiple first corrected images by applying multiple intensity mapping algorithms to the first image;
        - create multiple second corrected images by applying the multiple intensity mapping algorithms to the second image;
        - calculate (210) multiple displacement fields between the multiple first corrected images and the multiple second corrected images by performing an elastic registration between corresponding second corrected images and first corrected images;
        - calculate (218) an average displacement field using the multiple displacement fields;
        - transform (220) at least one of the first image and the second image using the average displacement field, wherein the first displacement field is one of the multiple displacement fields, wherein the first corrected image is one of the multiple first corrected images, wherein the second corrected image is one of the multiple second corrected images.

3.  The magnetic resonance imaging system of claim 1, wherein execution of the instructions further cause the processor to:

        - create a third corrected image by applying a second intensity mapping algorithm to the first image;
        - create a fourth corrected image by applying the second intensity mapping algorithm to the second image;
        - calculate a second displacement field between the first corrected image and the second corrected image by performing an elastic registration;
        - calculate an average displacement field by averaging the first displacement field and the second displacement field; and
        - transform at least one of the first image and the second image using the average displacement field.

4.  The magnetic resonance imaging system of claim 1, wherein the transformed image pair comprises a first transformed image and a second transformed image, wherein execution of the instructions further cause the processor to iteratively calculate (312) the transformed image pair by substituting (318) the first transformed image for the first image and substituting the second transformed image for the second image.

**5.** The magnetic resonance imaging system of claim 4, wherein execution of the instructions causes the processor to use a different intensity mapping algorithm for each iteration.

**6.** The magnetic resonance imaging system of claim 4 or 5, wherein execution of the instructions further causes the processor to:

- calculate a concatenated image displacement field by concatenating each of the first displacement fields calculated in each iteration; and
- create a concatenated transformed image pair by transforming at least one of the first image and the second image using at least the concatenated displacement field.

**7.** The magnetic resonance imaging system of claim 1, wherein the transformed image pair comprises a first transformed image and a second transformed image,
wherein execution of the instructions further cause the processor to:

- create a third corrected image by applying the first intensity mapping algorithm to the first transformed image;
- create a fourth corrected image by applying the first intensity mapping algorithm to the second transformed image;
- calculate a transformed image displacement field between the third corrected image and the fourth corrected image by performing an elastic registration;
- calculate a concatenated image displacement field by concatenating the first displacement field and the transformed image displacement field; and
- create a concatenated transformed image pair by transforming at least one of the first image and the second image using at least the concatenated image displacement field.

**8.** The magnetic resonance imaging system of claim 1, wherein the transformed image pair comprises a first transformed image and a second transformed image,
wherein execution of the instructions further cause the processor to:

- create a third corrected image by applying a second intensity mapping algorithm to the first transformed image;
- create a fourth corrected image by applying the second intensity mapping algorithm to the second transformed image;
- calculate a transformed image displacement field between the third corrected image and the fourth corrected image by performing an elastic registration;
- calculate a concatenated image displacement field by concatenating the first displacement field and the transformed image displacement field; and
- create a concatenated image pair by transforming at least one of the first image and the second image using at least the concatenated image displacement field.

**9.** The magnetic resonance imaging system of claim 1, wherein the elastic registration is performed using an elastic registration algorithm, wherein the elastic registration algorithm comprises a local search routine adapted for receiving a starting search location, wherein execution of the instructions further cause the processor to iteratively calculate the transformed image pair by using the first displacement field as the starting search location for a subsequent iteration.

**10.** The magnetic resonance imaging system of any one of the preceding claims, wherein execution of the instructions further causes the processor to apply an intensity correction to the first image and the second image after transforming at least one of the first image and the second image using the displacement.

**11.** The magnetic resonance imaging system of any one of the preceding claims, wherein execution of the instructions further causes the processor to create an averaged image by averaging the transformed image pair.

**12.** The magnetic resonance imaging system of any one of the preceding claims, wherein the first displacement field maps the first image onto the second image, wherein the creation of a transformed image pair by transforming at least one of the first image and the second image using at least the first displacement field is performed according to any one of the following: transforming the first image by the first displacement field; transforming the second image by the inverse of the first displacement field; and transforming the first image by one half of the first displacement field and transforming the second image by the inverse of one half of the first displacement filed.

**13.** The magnetic resonance imaging system of any one of the preceding claims, wherein the intensity mapping algorithm is any one of the following: a thresholding algorithm for generating a black and white image using a predetermined threshold, an intensity mapping algorithm with a predetermined intensity mapping, an algorithm which limits the maximum intensity to a predetermined intensity threshold, and an algorithm which limits the dynamic range of the image.

14. A computer program product comprising machine executable instructions (460, 462, 464, 466, 468) for execution by a processor (430) controlling a magnetic resonance imaging system (400), wherein the magnetic resonance imaging system is operable for acquiring magnetic resonance data (444, 446) from an imaging zone (408), wherein the magnetic resonance imaging system comprises a magnet (404) for generating a static magnetic field within the imaging zone, wherein the magnetic resonance imaging system further comprises a gradient coil system (410, 412) for generating a gradient magnetic field within the imaging zone, wherein execution of the instructions cause the processor to:

    - acquire (100, 204, 304) first magnetic resonance data (444) using a first echo-planar imaging pulse sequence (440), wherein the first echo-planar imaging pulse sequence is operable to cause the gradient coil amplifier to generate a phase encoding gradient with a first polarity;
    - acquire (102, 204, 304) second magnetic resonance data (446) using a second echo-planar imaging pulse sequence (442), wherein the second echo-planar imaging pulse sequence is operable to cause the gradient coil amplifier to generate the phase encoding gradient with a second polarity, wherein the first polarity and the second polarity have opposite values;
    - reconstruct (104, 206, 306) a first image (448) using the first magnetic resonance data;
    - reconstruct (106, 206, 306) a second image (450) using the second magnetic resonance data;
    - create (108, 208, 308) a first corrected image (452) by applying a first intensity mapping algorithm to the first image;
    - create (110, 208, 308) a second corrected image (454) by applying the first intensity mapping algorithm to the second image;
    - calculate (112, 210, 310) a first displacement field (456) between the first corrected image and the second corrected image by performing an elastic registration; and
    - create (114, 220, 312) a transformed image pair (458) by transforming at least one of the first image and the second image using at least the first displacement field.

15. A method of operating a magnetic resonance imaging system (400), wherein A magnetic resonance imaging system is operable for acquiring magnetic resonance data (444, 446) from an imaging zone (408), wherein the magnetic resonance imaging system comprises a magnet (404) for generating a static magnetic field within the imaging zone, wherein the magnetic resonance imaging system further comprises a gradient coil system (410, 412) for generating a gradient magnetic field within the imaging zone, wherein the method comprises the steps of:

    - acquiring (100, 204, 304) first magnetic resonance data (444) using a first echo-planar imaging pulse sequence (440), wherein the first echo-planar imaging pulse sequence is operable to cause the gradient coil amplifier to generate a phase encoding gradient with a first polarity;
    - acquiring (102, 204, 304) second magnetic resonance data (446) using a second echo-planar imaging pulse sequence (442), wherein the second echo-planar imaging pulse sequence is operable to cause the gradient coil amplifier to generate the phase encoding gradient with a second polarity, wherein the first polarity and the second polarity have opposite values;
    - reconstructing (104, 206, 306) a first image (448) using the first magnetic resonance data;
    - reconstructing (106, 206, 306) a second image (450) using the second magnetic resonance data;
    - creating (108, 208, 308) a first corrected image (452) by applying a first intensity mapping algorithm to the first image;
    - creating (110, 208, 308) a second corrected image (454) by applying the first intensity mapping algorithm to the second image;
    - calculating (112, 210, 310) a first displacement field (456) between the first corrected image and the second corrected image by performing an elastic registration; and
    - creating (114, 220, 312) a transformed image pair (458) by transforming at least one of the first image and the second image using at least the first displacement field.

## FIG. 1

```
┌─────────────────────────────────────────────┐
│      acquire first magnetic resonance data    │── 100
└─────────────────────────────────────────────┘
                      │
                      ▼
┌─────────────────────────────────────────────┐
│     acquire second magnetic resonance data    │── 102
└─────────────────────────────────────────────┘
                      │
                      ▼
┌─────────────────────────────────────────────┐
│     reconstruct first image using the first   │
│              magnetic resonance data          │── 104
└─────────────────────────────────────────────┘
                      │
                      ▼
┌─────────────────────────────────────────────┐
│  reconstruct second image using the second    │
│          magnetic resonance data              │── 106
└─────────────────────────────────────────────┘
                      │
                      ▼
┌─────────────────────────────────────────────┐
│          create first corrected image         │── 108
└─────────────────────────────────────────────┘
                      │
                      ▼
┌─────────────────────────────────────────────┐
│         create second corrected image         │── 110
└─────────────────────────────────────────────┘
                      │
                      ▼
┌─────────────────────────────────────────────┐
│        calculate first displacement field     │── 112
└─────────────────────────────────────────────┘
                      │
                      ▼
┌─────────────────────────────────────────────┐
│         create a transformed image pair       │── 114
└─────────────────────────────────────────────┘
```

FIG. 2

```
                        start  ~ 200

        N = number of intensity mapping algorithms to use   ~ 202
                              i = 1

        acquire first and second magnetic resonance data    ~ 204

              reconstruct first and second images           ~ 206

             create first and second corrected images       ~ 208

                  calculate first displacement field         ~ 210

                            i = i +1                         ~ 212

         ┌─ 214
         ◇          yes
        i < N  ─────────►  change intensity mapping algorithm
         ◇                                                   ~ 216
          │ no

              calculate average displacement field           ~ 218

                   create a transformed image pair           ~ 220

                              end  ~ 222
```

FIG.3

start ~300

N = number of iterations
i = 1 ~302

acquire first and second magnetic resonance data ~304

reconstruct first and second images ~306

create first and second corrected images ~308

calculate first displacement field ~310

create a transformed image pair ~312

i = i +1 ~314

i < N ~316

yes → subsitute transformed image pair for the first and second images ~318

no

end ~320

EP 2 685 275 A1

FIG. 4

17

FIG. 5

Europäisches
Patentamt

European
Patent Office

Office européen
des brevets

# EUROPEAN SEARCH REPORT

Application Number

EP 12 17 5561

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HOLLAND D ET AL: "Efficient correction of inhomogeneous static magnetic field-induced distortion in Echo Planar Imaging", NEUROIMAGE, ACADEMIC PRESS, ORLANDO, FL, US, vol. 50, no. 1, 1 March 2010 (2010-03-01), pages 175-183, XP026921261, ISSN: 1053-8119, DOI: 10.1016/J.NEUROIMAGE.2009.11.044 [retrieved on 2009-11-26] | 1-15 | INV. G01R33/565 G01R33/561 |
| Y | * Section "Methods" * ----- | 1-3,9-15 | |
| X | PAUL S. MORGAN ET AL: "Correction of spatial distortion in EPI due to inhomogeneous static magnetic fields using the reversed gradient method", JOURNAL OF MAGNETIC RESONANCE IMAGING, vol. 19, no. 4, 1 January 2004 (2004-01-01), pages 499-507, XP055045448, ISSN: 1053-1807, DOI: 10.1002/jmri.20032 * Section "Materials and Methods" * ----- | 1-3, 10-15 | |
| X | H-C CHANG ET AL: "A Modified Reversed Gradient Method using the Displacement Map Concept for Geometric Distortion Correction in EPI", PROCEEDINGS OF THE INTERNATIONAL SOCIETY FOR MAGNETIC RESONANCE IN MEDICINE, 14TH SCIENTIFIC MEETING AND EXHIBITION, SEATTLE, WASHINGTON, USA, 6-12 MAY 2006, 22 April 2006 (2006-04-22), page 2343, XP055045453, * the whole document * ----- | 1-3, 10-15 | TECHNICAL FIELDS SEARCHED (IPC) G01R |

-/--

The present search report has been drawn up for all claims

| Place of search | Date of completion of the search | Examiner |
|---|---|---|
| Munich | 26 November 2012 | Streif, Jörg Ulrich |

EPO FORM 1503 03.82 (P04C01)

Europäisches
Patentamt

European
Patent Office

Office européen
des brevets

# EUROPEAN SEARCH REPORT

**Application Number**

EP 12 17 5561

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VOSS H U ET AL: "Fiber tracking in the cervical spine and inferior brain regions with reversed gradient diffusion tensor imaging", MAGNETIC RESONANCE IMAGING, ELSEVIER SCIENCE, TARRYTOWN, NY, US, vol. 24, no. 3, 1 April 2006 (2006-04-01), pages 231-239, XP028004962, ISSN: 0730-725X, DOI: 10.1016/J.MRI.2005.12.007 [retrieved on 2006-04-01] * Sections "Theory", "Methods" * ----- | 1-3, 10-15 | |
| Y | GHOLIPOUR A ET AL: "On the accuracy of unwarping techniques for the correction of susceptibility-induced geometric distortion in magnetic resonance Echo-planar images", ENGINEERING IN MEDICINE AND BIOLOGY SOCIETY,EMBC, 2011 ANNUAL INTERNATIONAL CONFERENCE OF THE IEEE, IEEE, 30 August 2011 (2011-08-30), pages 6997-7000, XP032111474, DOI: 10.1109/IEMBS.2011.6091769 ISBN: 978-1-4244-4121-1 * Section "Methods" * ----- | 1-3,9-15 | TECHNICAL FIELDS SEARCHED (IPC) |

The present search report has been drawn up for all claims

| Place of search | Date of completion of the search | Examiner |
|---|---|---|
| Munich | 26 November 2012 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&: member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• **H. CHANG ; J.M. FITZPATRICK.** A Technique for Accurate Magnetic Resonance Imaging in the Presence of Field Inhomogeneities. *IEEE Transactions on Medical Imaging,* 1992, vol. 11, 319-329